# EUROPÄISCHE PATENTSCHRIFT

(11) **EP 1 128 418 B1**
(45) Veröffentlichungstag und Bekanntmachung des Hinweises auf die Patenterteilung: **25.04.2007**
(21) Anmeldenummer: 01104255.3
(22) Anmeldetag: 22.02.2001
(51) Int. Cl.: H01L 21/02, H01L 21/316, H01L 21/8246

(54) **Verfahren zur Herstellung einer ferroelektrischen Kondensatoranordnung**
Method of manufacturing a ferroelectric capacitor device
Méthode de fabrication d'un condensateur ferroélectrique

(30) Priorität: 25.02.2000 DE 10010288
(43) Veröffentlichungstag der Anmeldung: 29.08.2001
(73) Patentinhaber: Qimonda AG, 81739 München (DE)
(72) Erfinder: Weinrich, Volker, 75014 Paris (FR); Kasko, Igor, 81543 München (DE); Hartner, Walter, 81829 München (DE); Schindler, Günther, 80802 München (DE)
(74) Vertreter: Lange, Thomas

(56) Entgegenhaltungen:
- EP-A- 0 720 172
- JP-A- 11 039 860
- JP-A- 11 168 174
- US-A- 5 495 438

## Beschreibung

Die Erfindung betrifft ein Verfahren zur Herstellung einer ferroelektrischen Kondensatoranordnung mit wenigstens zwei unterschiedlichen Koerzitivspannungen.

Eine gegenwärtige Zielsetzung der Halbleitertechnik besteht darin, nicht-flüchtige Speicher mit einem Ferroelektrikum als Kondensatormaterial, sogenannte FeRAMs-(ferroelectric randomaccess memories), zu entwickeln. Ferroelektrika weisen eine Hysterese auf, die es ermöglicht, ohne angelegte elektrische Spannung Information entsprechend den vorliegenden beiden Polarisationszuständen dauerhaft zu speichern.

Um die Polarisation und damit auch die Information von dem einen Zustand in den anderen Zustand umzuschalten, muss eine gewisse Mindestspannung, die sogenannte Koerzitivspannung Vc, an den Kondensator angelegt werden.

Aus der deutschen Patentanmeldung DE 198 30 569 A1 ist eine FeRAM-Anordnung bekannt, bei der mehrere Kondensatoren mit unterschiedlichen Koerzitivspannungen an einen Auswahltransistor angeschlossen sind. Aufgrund der unterschiedlichen Koerzitivspannungen der Kondensatoren ist diese FeRAM-Anordnung in der Lage, mehrere Bits zu speichern. Zur Realisierung der unterschiedlichen Koerzitivspannungen der entsprechenden ferroelektrischen Dünnschichten werden Material- oder Schichtdickenvariationen vorgeschlagen.

Nachteilig ist, dass derartige ferroelektrische Dünnschichten mit unterschiedlichen Koerzitivspannungen in verschiedenen Arbeitsgängen mit jeweils unterschiedlichen Arbeitsparametern aufgebracht werden müssen.

Aus der Druckschrift JP 11 039860 A ist ein Verfahren zur Herstellung von ferroelektrischen Kondensatoranordnungen bekannt, bei welchem unterschiedliche Dicken der Ferroelektrikumschicht durch unterschiedliche Höhenniveaus bzw. unterschiedliche Dicken der Elektrodenschichten erzeugt werden.

Aus der Druckschrift JP 11 168174 A ist ein Verfahren bekannt, bei welchem Gate-Elektroden, welche unterhalb der unteren Elektrodenschicht angeordnet sind, eine Höhenmodulation in der unteren Elektrodenschicht und eine Dickenvariation in der Ferroelektrikumschicht verursachen.

Aus den Druckschriften US 5,495,483 und EP 0 720 172 A2 sind jeweils ferroelektrische Speicherzellen zur Speicherung von Multibit-Daten bekannt, welche eine Parallelanordnung zweier ferroelektrischer Kondensatoren mit unterschiedlichen Koerzitivspannungen beinhalten.

Der Erfindung liegt die Aufgabe zugrunde, ein mit geringem Aufwand durchführbares, verbessertes Verfahren zur Herstellung einer ferroelektrischen Kondensatoranordnung mit zwei oder mehr unterschiedlichen Koerzitivspannungen anzugeben.

Diese Aufgabe wird durch ein Verfahren gemäß den Merkmalen des Anspruchs 1 gelöst.

Demnach besteht der Grundgedanke der Erfindung darin, eine wenigstens zwei unterschiedliche Höhenniveaus aufweisende Topologie der ersten Elektrodenstruktur vorzusehen, um eine Dickenvariation der Ferroelektrikumschicht herbeizuführen. Dabei wird ausgenutzt, dass das zur Abscheidung der Ferroelektrikumschicht eingesetzte Schleuderbeschichtungsverfahren eine einebnende Wirkung zeigt, d.h. über erhabenen Bereichen der ersten Elektrodenstruktur geringere Schichtdicken als über vertieften Bereichen der ersten Elektrodenstruktur erzeugt werden.
Vor der Erzeugung der ersten Elektrodenstruktur wird eine Stufe in einer Barriereschicht gebildet. Bei der Abscheidung der Elektrodenstruktur überträgt sich die Barriereschichtstufe in die Elektrodenstruktur.

Durch das erfindungsgemäße Verfahren wird die Ferroelektrikumschicht mit variierender Schichtdicke aufwandsgünstig in einem einzigen Arbeitsgang abgeschieden.

Die Kondensatoranordnung kann in Form eines einzigen Kondensators mit Ferroelektrikum-Schichtabschnitten unterschiedlicher Koerzitivspannungen realisiert sein. Ein solcher Kondensator weist dann mehrere Schaltpunkte (d.h. mehr als zwei Speicherzustände) auf. Eine andere Möglichkeit besteht darin, zwei oder mehr Kondensatoren in der Kondensatoranordnung auszubilden. Dies geschieht dadurch, dass eine Auftrennung der ersten Elektrodenstruktur oder der zweiten Elektrodenstruktur oder auch beider Elektrodenstrukturen zu geeigneten Prozeßzeitpunkten vorgenommen wird.

Die Erfindung wird nachfolgend anhand eines Ausführungsbeispiels unter Bezugnahme auf die Zeichnung näher erläutert. In dieser zeigt:
- Fig. 1: eine schematische Schnittdarstellung einer FeRAM-Speicherzelle mit Schalttransistor und ferroelektrischer Kondensatoranordnung, bei welcher die dargestellte Schichtenfolge nicht Gegenstand der Erfindung ist; und
- Fig. 2: eine schematische Schnittdarstellung einer Schichtenfolge der Kondensatoranordnung zur Erläuterung der Erfindung.

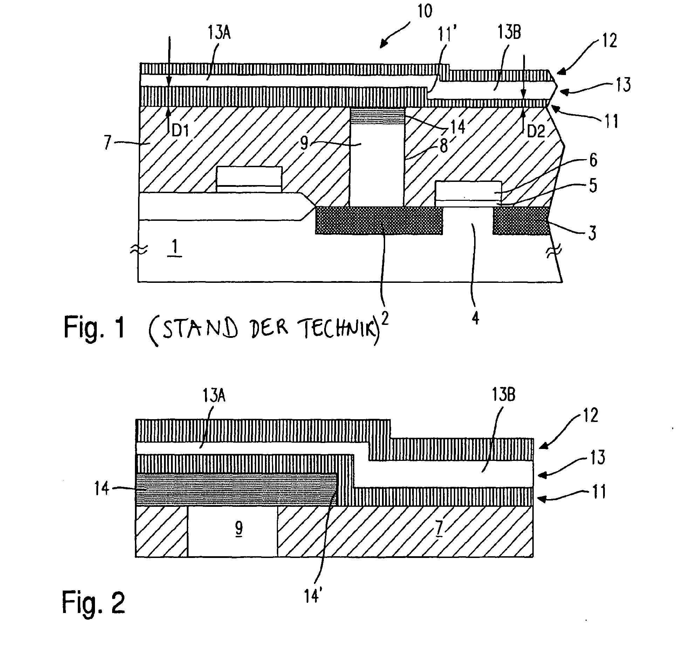

Fig. 1 dient der Erläuterung eines in Bezug auf die Kondensatoranordnung nicht von der Erfindung umfassten Herstellungsablaufs einer ferroelektrischen Kondensatoranordnung am Beispiel einer FeRAM-Speicherzelle.

Auf einem beispielsweise p-dotierten Si-Halbleitersubstrat (Wafer) 1 wird mittels üblicher planartechnischer Verfahren (Schichtabscheidung, Schichtstrukturierung unter Verwendung von Lithographie- und Ätztechniken, Schichtdotierung) ein N-Kanal MOS-Transistor aufgebaut. Ein n⁺-dotiertes Drain-Gebiet 2 ist von einem n⁺-dotierten Source-Gebiet 3 über einen zwischenliegenden Kanal 4 aus Substratmaterial getrennt. Oberhalb des Kanals 4 liegt eine dünne Gate-Oxidschicht 5. Auf der Gate-Oxidschicht 5 wird eine Gate-Elektrode 6 angebracht, welche die Wortleitung der Speicherzelle bildet.

Auf dem MOS-Transistor 2, 3, 4, 5, 6 wird eine Deckoxidschicht 7 abgelagert. Es wird ein Kontaktloch 8 in die Deckoxidschicht 7 eingebracht. Das Kontaktloch 8 wird mit einer elektrischen Anschlußstruktur 9 (sog. "plug") bestehend z.B. aus dotiertem Polysilizium oder einem Metall gefüllt.

Statt des hier dargestellten MOS-Transistors 2, 3, 4, 5, 6 kann auch ein anderes monolithisches Halbleiter-Funktionselement vorgesehen sein.

Oberhalb der Deckoxidschicht 7 wird eine ferroelektrische Kondensatoranordnung 10 gebildet.

Die Kondensatoranordnung 10 weist eine untere Elektrodenstruktur 11 (bottom-Elektrode), eine obere Elektrodenstruktur 12 (top-Elektrode) und zwischenliegend ein ferroelektrisches Kondensatormaterial 13 auf. Zwischen der unteren Elektrodenstruktur 11 und der Anschlußstruktur 9 befindet sich, sofern erforderlich, eine Barriereschicht 14, deren Aufgabe es ist, zu verhindern, dass durch die Elektrodenstruktur 11 hindurchdiffundierender Sauerstoff an der Anschlußstruktur 9 eine hochohmige Sperrschicht aufbaut.

Die beiden Elektrodenstrukturen 11, 12 bestehen aus einem inerten Material wie beispielsweise Pt, Ir oder Ru. Bei dem Ferroelektrikum 13 kann es sich beispielsweise um SrBi₂Ta₂O₉ [SBT], SrBi₂Ta₂₋ₓNbₓO₉ [SBTN] oder auch andere Ferroelektrika wie Pb(Zr,Ti)O [PZT], BiTiO [BTO], PLZT, BZTO usw. handeln. Die Barriereschicht 14 kann z.B. aus IrO₂ gebildet sein.

Das Ferroelektrikum 13 weist wenigstens zwei Abschnitte 13A, 13B mit unterschiedlichen Schichtdicken auf. Die unterschiedlichen Schichtdicken bewirken, dass die Kondensatoranordnung 10 unterschiedliche Koerzitivspannungen Vc1, Vc2 aufweist. Die Koerzitivspannung Vc1 im Abschnitt 13A mit geringerer Schichtdicke ist kleiner als die Koerzitivspannung Vc2 im Abschnitt 13B mit größerer Schichtdicke, d.h. die Umschaltung der beiden Polarisationszustände findet in dem Abschnitt 13A "früher" (d.h. bei einer niedrigeren angelegten Spannung) als in dem Abschnitt 13B statt.

Die in Fig. 1 dargestellte Kondensatoranordnung 10 läßt sich als Parallelschaltung von zwei Kondensatoren mit unterschiedlichen Koerzitivspannungen auffassen. Sie kann (in nicht dargestellter Weise) aber auch aus zwei (oder mehr) separat ansteuerbaren Kondensatoren mit unterschiedlichen Koerzitivspannungen bestehen. In diesem Fall sind die untere Elektrodenstruktur 11 und/oder die obere Elektrodenstruktur 12 im Bereich der Übergangsstufen 11' zwischen den Abschnitten geringerer Schichtdicke 13A und größerer Schichtdicke 13B elektrisch getrennt.

Die Herstellung der ferroelektrischen Kondensatoranordnung 10 kann folgendermaßen erfolgen.

Nach der bereits beschriebenen Herstellung des Transistors 2, 3, 4, 5, 6 und der elektrischen Anschlußstruktur 9 wird eine Vertiefung in letztere hineingeätzt. Die Vertiefung wird mit der Barriereschicht 14 gefüllt. Anschließend kann ein Planarisierungsschritt durchgeführt werden.

In einem nächsten Schritt wird die untere Elektrodenstruktur 11 auf der Deckoxidschicht 7 und der Barriereschicht 14 abgeschieden. Hierfür kann ein Sputter-Verfahren eingesetzt werden. Die Schichtdicke der abgeschiedenen Elektrodenstruktur 11 beträgt D1.

In einem darauffolgenden Schritt wird die untere Elektrodenstruktur 11 abschnittsweise bis auf eine verbleibende Schichtdicke D2 weggeätzt. Dies bewirkt die Ausbildung der Stufe 11' (Stufenhöhe = D1 - D2) in der unteren Elektrodenstruktur 11. Die Stufenhöhe D1 - D2 muss dabei größer als die gewünschte Dickendifferenz zwischen den beiden Abschnitten 13A und 13B des Ferroelektrikums 13 sein.

In einem weiteren, optionalen Schritt wird die untere Elektrodenstruktur 11 der Kondensatoranordnung 10 z.B. am Fuße der Stufe 11' elektrisch getrennt. In diesem Fall wird eine Kondensatoranordnung bestehend aus (mindestens) zwei Kondensatoren realisiert, wobei die unterhalb des Schichtabschnitts 13B erzeugte Kondensatorelektrode dann durch geeignete Maßnahmen (z.B. eine weitere elektrische Anschlußstruktur) ebenfalls elektrisch kontaktierbar sein muss.

Nun wird mittels Schleuderbeschichtung ("spin-on"-Verfahren) das Ferroelektrikum auf die untere Elektrodenstruktur 11 aufgebracht. Dabei wird das in einem Lösungsmittel gelöste Ferroelektrikum auf das Substrat 1 aufgetropft und das Substrat 1 sodann mit einer Drehtellereinrichtung in Rotation (typischerweise 2000 Umdrehungen pro Minute) versetzt. Durch die Zentrifugalkraft wird das Lösungsmittel mit dem Ferroelektrikum bis auf eine dünne verbleibende Schicht radial nach außen weggeschleudert. Auf dem erhabenen Abschnitt der unteren Elektrodenstruktur 11 stellt sich ein Flüssigkeitsfilm ein, der dünner als der Flüssigkeitsfilm über dem vertieften Abschnitt der unteren Elektrodenstruktur 11 ist. Bereits während der Rotation verdampft das Lösungsmittel teilweise aus der zurückbleibenden Ferroelektrikumschicht.

In mehreren nachfolgenden Temperaturbehandlungsschritten wird eine vollständige Verdampfung des Lösungsmittels erreicht und eine Kristallisierung der gewünschten ferroelektrischen Verbindung bewirkt. Dies hat eine erhebliche Dickenreduktion der genannten Schicht zur Folge und resultiert in der Fertigstellung der in Fig. 1 gezeigten Ferroelektrikumschicht 13.

Allgemein wird durch das beschriebene Schleuderbeschichtungsverfahren bewirkt, dass auf erhabenen Oberflächenabschnitten dünnere Ferroelektrikumschichten entstehen als auf tieferliegenden Oberfächenabschnitten. Durch die Höhendifferenz D1 - D2 kann also der Grad der Dickenvariation der Ferroelektrikumschicht 13 eingestellt werden. Das Prinzip läßt sich selbstverständlich auch auf mehr als zwei Höhenstufen und damit auf mehr als zwei Schichtdicken der Ferroelektrikumschicht 13 ausdehnen.

Bei einer Höhendifferenz D1 - D2 = 220 nm betrug die Schichtdicke des Abschnitts 13A der Ferroelektrikumschicht (SBT) 13 etwa 35 nm und die Schichtdicke des Abschnitts 13B der Ferroelektrikumschicht 13 etwa 60 nm.

Zur Fertigstellung der Kondensatoranordnung 10 wird über der Ferroelektrikumschicht 13 die obere Elektrodenstruktur 12 abgeschieden und, sofern gewünscht, ebenfalls geteilt.

Die (äußere) Strukturierung der aufgebrachten Schichten 11, 12, 13 zur Realisierung einzelner Kondensatoranordnungen auf dem Substrat kann anschließend durch gemeinsame Ätzung aller drei Schichten 11, 12, 13 erfolgen.

Anhand der Fig. 2 wird ein Ausführungsbeispiel der Erfindung zur Erzeugung geeigneter Oberflächentopologien der unteren Elektrodenstruktur 11 erläutert. Einander im Vergleich mit Fig. 1 entsprechende Teile sind mit denselben Bezugszeichen versehen.

Bei dem erfindungsgemäßen Ausführungsbeispiel (siehe Fig. 2) wird nach der Herstellung des Transistors 2, 3, 4, 5, 6 und der elektrischen Anschlußstruktur 9 eine Barriereschicht 14 auf der Deckoxidschicht 7 abgeschieden.

Die Barriereschicht 14 wird dann bereichsweise entfernt, wobei die Barriereschichtstufe 14' stehenbleibt.

In einem nächsten Schritt wird die untere Elektrödenstruktur 11 abgeschieden. Die Barriereschichtstufe 14' wird dabei in den Oberflächenverlauf der unteren Elektrodenstruktur 11 übertragen.

Nach einer optionalen internen Strukturierung (Trennung) der unteren Elektrodenstruktur 11 wird die Ferroelektrikumschicht 13 unter Verwendung des bereits beschriebenen Schleuderbeschichtungsverfahrens erzeugt. Abschließend wird die obere Elektrodenstruktur 12 aufgebracht und gegebenenfalls geeignet aufgetrennt.

## Patentansprüche

1. Verfahren zur Herstellung einer ferroelektrischen Kondensatoranordnung (10) mit wenigstens zwei unterschiedlichen Koerzitivspannungen (Vc1, Vc2), mit den Schritten:
- Erzeugen einer ersten Elektrodenstruktur (11);
- Erzeugen einer Ferroelektrikumschicht (13) variierender Dicke auf der ersten Elektrodenstruktur (11);
- Erzeugen einer zweiten Elektrodenstruktur (12) auf der Ferroelektrikumschicht (13);
wobei,
- die Oberfläche der ersten Elektrodenstruktur (11) wenigstens zwei unterschiedliche Höhenniveaus ausbildet; und
- zur Erzeugung der Ferroelektrikumschicht (13) ein Schleuderbeschichtungsverfahren eingesetzt wird,
**dadurch gekennzeichnet,**
- **dass** vor der Erzeugung der ersten Elektrodenstruktur (11) eine Stufe (14') in einer (11) Sauerstoff-Diffusionsbarriereschicht (14) gebildet wird, die beim Erzeugen der ersten Elektrodenstruktur (11) in den Oberflächenverlauf der ersten Elektrodenstruktur (11) zur Herbeiführung der zwei Höhenniveaus übertragen wird.

2. Verfahren nach Anspruch 1,
**dadurch gekennzeichnet,**
- **dass** zur Ausbildung von wenigstens zwei Kondensatoren eine Auftrennung der ersten Elektrodenstruktur (11) vorgenommen wird.

3. Verfahren nach Anspruch 1 oder 2,
**dadurch gekennzeichnet,**
- **dass** zur Ausbildung von wenigstens zwei Kondensatoren eine Auftrennung der zweiten Elektrodenstruktur (12) vorgenommen wird.

## Claims

1. Method for manufacturing a ferroelectric capacitor arrangement (10) having at least two different coercitive voltages (Vc1, Vc2), having the steps:
- a first electrode structure (11) is produced;
- a layer (13) of ferroelectric substance of varying thickness is produced on the first electrode structure (11);
- a second electrode structure (12) is produced on the layer (13) of ferroelectric substance;
- the surface of the first electrode structure (11) forming at least two different levels; and
- a spin coating method being used to produce the layer (13) of ferroelectric substance,
**characterized**
- **in that**, before the first electrode structure (11) is produced, a step (14') is formed in an oxygen diffusion barrier layer (14) which, while the first electrode structure (11) is being produced, is transferred into the surface profile of the first electrode structure (11) in order to bring about the two levels.

2. Method according to Claim 1,
**characterized**
- **in that** the first electrode structure (11) is divided in order to form at least two capacitors.

3. Method according to Claim 1 or 2,
**characterized**
- **in that** the second electrode structure (12) is divided in order to form at least two capacitors.

## Revendications

1. Procédé de fabrication d'un condensateur (10) ferroélectrique ayant au moins deux tensions (Vc1, Vc2) coercitives différentes, comprenant les stades dans lesquels :
- on produit une première structure (11) d'électrode ;
- on produit une couche (13) ferroélectrique d'épaisseur variable sur la première structure (11) d'électrode ;
- on produit une deuxième structure (12) d'électrode sur la couche (13) ferroélectrique ;
dans lequel
- la surface de la première structure (11) d'électrode forme au moins deux niveaux différents en hauteur ; et
- pour la production de la couche (13) ferroélectrique on utilise un procédé de revêtement par centrifugation,
**caractérisé**
- **en ce qu'**avant la production de la première structure (11) d'électrode on forme un palier (14') dans une couche (14) formant barrière de diffusion de l'oxygène, palier qui, lors de la production de la première structure (11) d'électrode, se transpose dans le tracé de surface de la première structure (11) d'électrode pour donner le deuxième niveau en hauteur.

2. Procédé suivant la revendication 1,
**caractérisé**
- **en ce que**, pour former les au moins deux condensateurs, on effectue une séparation de la première structure (11) d'électrode.

3. Procédé suivant la revendication 1 ou 2,
**caractérisé**
- **en ce que**, pour former les au moins deux condensateurs, on effectue une séparation de la deuxième structure (12) d'électrode.
